# EUROPEAN PATENT APPLICATION

(11) **EP 2 030 779 A1**
(43) Date of publication of application: **04.03.2009**
(21) Application number: 07740387.1
(22) Date of filing: 29.03.2007
(51) Int. Cl.: B32B 18/00, B32B 9/00, B32B 27/20

(54) **THIN FILM AND THIN FILM LAMINATE USING THE SAME**

(30) Priority: 30.03.2006 JP 2006095788; 25.08.2006 JP 2006229849
(71) Applicant: Tomoegawa Co., Ltd., Tokyo 104-8335 (JP)
(72) Inventor: INOUE, Tomohito, Shizuoka-shi, Shizuoka 421-0192 (JP); MOTEGI, Katsumi, Shizuoka-shi, Shizuoka 421-0192 (JP); TSUDA, Hajime, Shizuoka-shi, Shizuoka 421-0192 (JP)
(74) Representative: Downing, Michael Philip
(86) International application number: PCT/JP2007/056949
(87) International publication number: WO 2007/114289

(57) **Abstract**

The object of the present invention is to provide a thin film which has excellent heat resistance and water resistance together with excellent flexibility, and a thin film laminate comprising the thin film, and the present invention provides a thin film comprising a heat-resistant fluid between layers comprising heat-resistant flakes.

## Description

### TECHNICAL FIELD

The present invention relates to a thin film which can be used as a film substrate for displays and has excellent heat resistance, water resistance, and flexibility, and a thin film laminate comprising the same.
Priority is claimed on Japanese Patent Application No. 2006-095788, filed on March 30, 2006, and Japanese Patent Application No. 2006-229849, filed on August 25, 2006, the contents of which are incorporated herein by reference in their entirety.

### BACKGROUND ART

A display used in a conventional cathode-ray tube method is rapidly changing to a display in a liquid crystal method (LCD) because the latter has excellent mobile ability and space-saving ability. In addition, a display in an organic electroluminescence method which is a spontaneous optical device and is excellent in luminosity, vividness, and power consumption is beginning to be produced as a next generation display. The display in an organic electroluminescence method is far superior to the display in a conventional cathode-ray tube method in mobile ability and space-saving ability. However, since the display still comprises a glass plate as a substrate, it is relatively heavy and has a problem in that breakage occurs.
In order to solve the problems, a part of the display in a liquid crystal method uses a film substrate (this is called "PlaCell"). However, since the organic electroluminescence EL display, which is highlighted as a next generation display, needs a transparent conductive film having low resistance, a heat treatment at temperatures exceeding 250°C is essential. There were no plastic substrates which can withstand the heat treatment under such high temperatures. However, clay thin films have attracted attention as a material which may satisfy these demands in recent years.

The clay thin film has excellent transparency and flexibility. In addition, since it has a structure in which particles are precisely orientated and layered, it has excellent gas barrier properties. Furthermore, it contains an inorganic material as a main component, therefore, it has extremely excellent heat resistance (for example, refer to Patent Document 1). However, the clay thin film is used as a film substrate for a liquid or organic EL display, there is a problem in terms of water resistance. In general, since clay contains hydrophilic cations between layers, it is highly hygroscopic. For this reason, clay is not suitable as a material used in a film substrate for an organic EL display in which there is a concern about degradation due to moisture. In order to solve this problem, a method in which hydrophilic cations between clay layers are replaced with hydrophobic cations is suggested. However, when hydrophilic cations are replaced with hydrophobic cations, the flexibility of the clay film is decreased. Therefore, it is necessary to add a resin component to increase flexibility. However, in general, a resin component has poor heat resistance. There was a problem that the heat resistance of clay could not fully be demonstrated.
Patent Document No. 1: Japanese Unexamined Patent Application, First Publication No. 2005-104133

### DISCLOSURE OF THE INVENTION

### PROBLEMS TO BE SOLVED BY THE INVENTION

As explained above, it is necessary to obtain a clay thin film which has excellent transparency, heat resistance, water resistance, and flexibility, in order to use it as a film substrate for an organic EL display. Therefore, an object of the present invention is to provide a thin film which has sufficient heat resistance and water resistance together with excellent flexibility, and a thin film laminate comprising the thin film.

### MEANS FOR SOLVING THE PROBLEM

The thin film of the present invention comprises a heat-resistant fluid between layers comprising heat-resistant flakes.
In addition, the thin film laminate of the present invention comprises the thin film, and one or more of at least one of an inorganic thin film and an organic thin film is layered on one surface or both surfaces of the thin film.

### EFFECTS OF THE PRESENT INVENTION

The thin film of the present invention is an excellent thin film which has all of heat resistance, water resistance, and flexibility.
Since the thin film of the present invention has excellent properties, it can be used in various products. For example, the thin film of the present invention can be used as a substrate for electronic paper, a sealing film for an electronic device, a lens film, a film for a light guide plate, a prismatic film, a film for a retardation plate, a film for a polarization plate, a film for compensating view angle, a film for a PDP, a film for an LED, an optical communication member, a film for a touch panel, a substrate for various functional films, a film for an electronic device which allows the inside thereof to be viewed, a film for an optical recording medium such as a video disc, CD, CR-R, CR-RW, DVD, MO, MD, a phase-change disc, and an optical card, a film for sealing a fuel cell, a film for a solar cell, and the like.
The thin film laminate of the present invention comprises at least one of an inorganic thin film and an organic thin film, and the thin film, wherein one or more of the inorganic thin film and/or the organic thin film is layered on one surface or both surfaces of the thin film. Therefore, the thin film laminate has high gas barrier properties. The thin film laminate of the present invention can be preferably used as a film substrate for a liquid or an organic EL display.

### BRIEF DESCRIPTION OF THE DRAWINGS

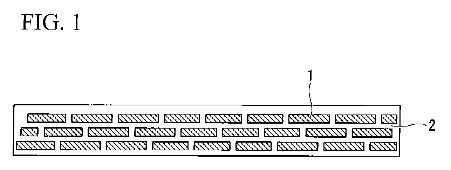

[FIG. 1] FIG. 1 is a schematic sectional view showing one example of the thin film according to the present invention.

### EXPLANATION OF REFERENCE SYMBOLS

- 1: heat-resistant flake
- 2: heat-resistant fluid

### BEST MODE FOR CURRYING OUT THE INVENTION

Below, the thin film and thin film laminate of the present invention are explained in detail.
The thin film of the present invention has a structure in which heat-resistant flakes are orientated and layered There is a heat-resistant fluid between the heat-resistant flakes. The thickness of the thin film is in a range from about 1 to about 3,000 µm.

FIG. 1 is a schematic sectional view showing one example of the thin film according to the present invention. As shown in FIG. 1, plural heat-resistant flakes 1 having a thickness of 0.5 to 2 nanometers, and a particle diameter of I µm or less are orientated and layered. There is a heat-resistant fluid 2 between the heat-resistant flakes 1.
Examples of the heat-resistant flakes 1 include natural or synthesized clay mineral. Examples of the clay mineral include mica, vermiculite, montmorillonite, iron montmorillonite, beidellite, saponite, hectorite, stevensite, nontronite, magadiite, ilerite, kanemite, layered titanic acid, and smectite. These are used alone or in combination.

The heat-resistant fluid 2 which is between the heat-resistant flakes 1, is preferably a liquid or paste material which does not undergo transformation such as decomposition, and can be boiled at high temperatures such as 200°C or greater, similar to a lubricant.
The content of the heat-resistant fluid 2 is preferably in a range from 1 to 60% by weight, and more preferably in a range from 5 to 60% by weight relative to 100% by weight of the entire thin film. When it is 1% by weight or more, it is easy to obtain flexibility of the thin film. When it is 60% by weight or less, self-sustainability of the thin film can be easily obtained.
Examples of the heat-resistant fluid 2 include polyalkylene glycol, phosphoric ester, alkylbenzene, poly-α-olefin, polyol ester, alkyl naphthalene, silicone oil, halocarbon, polyaryl alkane, polyphenyl, silicate, and polyphenyl ether.

Among these heat-resistant fluids, heat-aesistant fluids having a reactive functional group are preferable. In particular, silicone oil is more preferable. Silicone oil has a smaller variation in viscosity depending on temperature than those of other heat-resistant fluids.

In addition, among silicone oils, silicone oils having a reactive functional group are preferably used. Reactive modified silicone oils are more preferable.
Here, "reactive modified silicone oil" means silicone oils in which a reactive functional group is introduced in a part of methyl groups to provide compatibility to organic material, reactivity, solubility to water, emulsifiability, water repellency, and the like.

The reactive functional groups in the silicone oil are bound chemically, or crosslinked by a curing agent or a reaction auxiliary agent. Thereby, the silicone oil having fluidity becomes rubbery or soft, and can provide flexibility to a self-sustainable film.

Among these, methyl phenyl silicone oil or modified methyl phenyl silicone oil are preferable. The chemical structure of methyl phenyl silicone oil is shown in below.

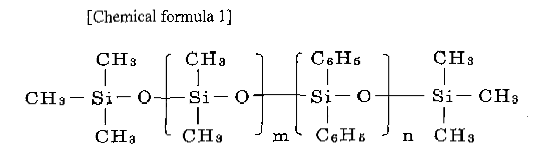

(In the chemical formula, m and n are an integer of 1 or greater.)

In addition, epoxy-modified silicone oil is also preferable. When the heat-resistant fluid is epoxy-modified silicone oil, and the thin film contains an epoxy resin curing agent, or further contains epoxy resin, an epoxy group in the epoxy-modified silicone oil reacts. Thereby, a self-sustainable film in silicone rubber conditions is obtained.
When the thin film contains epoxy resin, epoxy resin reacts with epoxy-modified silicone oil, which is the heat-resistant fluid to provide crosslinking Thereby, a self-sustainable film having higher strength and flexibility can be obtained.
A case in which the reactive functional group in silicone oil is an organic group, such as methyl phenyl group, and epoxy group is explained above. However, the present invention is not limited to these groups. In the present invention, any reactive functional groups can be used as long as it has the aforementioned effects.

The heat-resistant fluid used in the present invention preferably contains hydrophobic cationic compounds. When the heat-resistant fluid contains a hydrophobic cationic compound, the heat-resistant fluid exists readily between the heat-resistant flakes. In general, clay contains hydrophilic exchangeable cations. The hydrophilic exchangeable cations are readily exchanged with hydrophobic cations.
Examples of the hydrophobic cationic compound include a quarternary ammonium salt, such as a dimethyl distearyl ammonium salt and a trimethyl stearyl ammonium salt, an ammonium salt which has a benzyl group and a polyoxyethylene group, a quarternary phosphonium salt, a pyridinium salt, and an imidazolium salt.

Clay can be organized by using ion exchange ability with a hydrophobic cationic compound. Specifically, hydrophilic cations of montmorillonite can be exchanged using the hydrophobic cationic compound. Thereby, clay is easily dispersed in an organic solvent, and intercalation of the silicone oil is easily performed.
The hydrophobic cationic compounds are shown below by chemical formulae. The chemical formulae (1), (2), (3), and (4) are for a quarternary ammonium salt, a quarternary phosphonium salt, a pyridinium salt, and an imidazolium salt respectively.

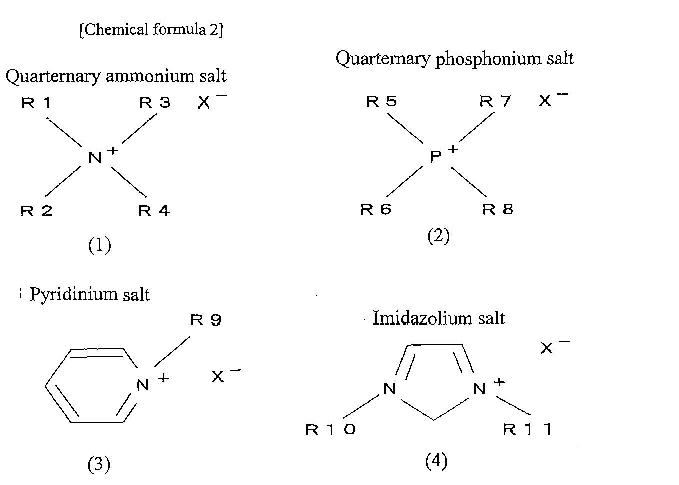

(In the chemical formulae, X is a halogen atom, R1 to R11 are an alky group or a phenyl group.)

In order to increase the strength of the thin film, the heat-resistant fluid contains preferably resin which is in a solid state at room temperature. Resins which are in a solid state at room temperature are not limited. Examples of the resin include epoxy resin, polyamide imide, and silicone resins which are polymerized by heat or ultraviolet rays.

In addition, the resin in a solid state at room temperature preferably has a functional group reactive with the heat-resistant fluid.
Examples of a preferable combination between the resin and the heat-resistant fluid include the combination between epoxy resin and the silicone oil having an epoxy group, and the combination between polyimide resin or silicone resin and the silicone oil having an amino group.
When the heat-resistant fluid and the resin having a functional group reactive with the heat-resistant fluid are combined, the resin reacts with the heat-resistant fluid to provide a crosslinking structure. As a result, the strength of the thin film is increased.
The content of the resin having a functional group reactive with the heat-resistant fluid is preferably 50% by weight or less relative to 100% by weight of the thin film. When it is 50% by weight or less, it is possible to maintain a preferable weight ratio of the heat-resistant flakes, and excellent heat resistance and gas barrier properties can be easily obtained.

For example, the thin film of the present invention can be produced by the following steps.
(1) After the heat-resistant flakes and a hydrophobic cationic compound are dispersed in pure water, solid and liquid are separated, and the solid is dried to obtain organized clay.
(2) After dispersing, the obtained organized clay and the heat-resistant fluid are dispersed in an organic solvent and the dispersant is left to rest in a container or on a film. Thereby, the heat-resistant flakes are deposited, and the organic solvent is volatilized to remove it. Then, this is dried at temperatures in a range from 60 to 300°C to obtain a self-sustainable thin film.
It is preferable to subject the heat-resistant flakes to a silylation treatment with a silane coupling agent or a silane compound before the step (1). Thereby, compatibility to the heat-resistant fluid and reactivity of the heat-resistant flakes are improved.

In addition, it is possible to add various additives, such as a hardening auxiliary agent, an antioxidant, a surface active agent, a pigment, and a leveling agent in the step (1) in which the heat-resistant flakes and the hydrophobic cationic compound are dispersed in pure water or the step (2) in dispersing in an organic solvent.

The thin film of the present invention can be produced by dispersing the heat-resistant flakes and the heat-resistant fluid in a solvent, coating the obtained mixture on a a substrate to form a film, and peeling the film from the substrate after being subjected to a heat treatment.

The thin film of the present invention can be used alone. However, in order to obtain higher gas barrier properties, chemical resistance, and surface smoothness, it is possible to make a thin film laminate by layering one or more of an inorganic thin film and/or an organic thin film on one surface or both surfaces of the thin film of the present invention
The inorganic thin film and the organic thin film are not limited, and the most preferable one can be selected depending on the application. For example, when an inorganic thin film comprising silicon oxide or silicon oxide nitride is formed on the thin film of the present invention by sputtering or a plasma CVD method, higher gas barrier properties and chemical resistance can be obtained. In addition, when an organic polymer is coated on the thin film of the present invention to form an organic thin film, it is possible to provide smoothness to the surface thereof. It is possible to obtain properties which cannot be obtained by only the thin film of the present invention by layering the surface of the thin film with the inorganic thin film or the organic thin film.

The best mode of the present invention is explained in detail referring to Examples below However, the present invention is not limited to Examples.

### Examples

### Example 1

### (Production of organized clay)

After dispersing 5 g of tetradecyl trimethyl ammonium bromide as the hydrophobic cationic compound in 50 g of pure water, 5 g of synthesized smectite (marketed by Kunimine Industries Co., Ltd., trade name: Smecton SA) as the heat-resistant flakes was added, and completely dispersed and swelled. After removing the liquid contained in the mixture by carrying out a solid-liquid separation using a centrifugal separator, 50 g of pure water was further added, dispersed, and the solid and liquid were separated again. After repeating the dispersion and the solid-liquid separation until foam was not formed, the moisture was thoroughly removed by a dryer. Thereby, hydrophilic exchangeable cations contained in the clay were exchanged with tetradecyl trimethyl ammonium ions. Organized clay having swelling properties to toluene, which is a non-polar solvent, was obtained.

### (Production of a clay thin film)

The obtained organized clay was crushed. 5 g of the organized clay was dispersed and swollen in 100 g of toluene. Then, 4 g of dimethyl phenyl silicone oil as the heat-resistant fluid was added, and dispersed. The obtained solution was poured in a container made of fluorine resin having a flat bottom and a depth of 2 mm. After removing the solvent by leaving to rest at room temperature, remaining solvent was thoroughly removed by a hot wind dryer at 150°C to obtain a thin film of this example. The thin film could be easily peeled from the container. The thin film was transparent and flexible, had a thickness of 100 µm, and contained silicone oil.

### Example 2

A thin film of this example was prepared in a manner identical to that of Example 1 of the present invention, except that octadecyl triphenyl phosphonium bromide was used as the hydrophobic cations.

### Example 3

A thin film of this example was prepared in a manner identical to that of Example 1 of the present invention, except that 2 g of thermosetting epoxy resin was added at the same time as adding dimethyl silicone oil.

### Example 4

Ultraviolet curable acryl resin was coated onto the both surfaces of the thin film obtained in Example 2 such that the thickness was 2 µm. After that, a silicone oxide nitride film having a thickness of 60 nm was formed on the coated resin using a reactive sputtering device, and thereby the thin film laminate of this example was obtained.

### Example 5

A thin film of this example was prepared in a manner identical to that of Example 2 of the present invention, except that alkyl benzene (marketed by Nippon Oil Corporation; trade name: Great Alkene 200P) was used as the heat-resistant fluid.

### Example 6

A thin film of this example was prepared in a manner identical to that of Example 2 of the present invention, except that poly-α-olefin (marketed by Idemitsu Kousan Co., Ltd. trade name: PAO5010) was used as the heat-resistant fluid.

### Example 7

A thin film of this example was prepared in a manner identical to that of Example 2 of the present invention, except that polyol ester (marketed by Kao Corporation; trade name: Kaolube 262) was used as the heat-resistant fluid.

### Example 8

A thin film of this example was prepared in a manner identical to that of Example 2 of the present invention, except that polyphenyl ether (marketed by Matsumura Oil Research Corporation; trade name: Moresco-Hirad RP-42R) was used as the heat-resistant fluid.

### Comparative Example 1

5 g of synthesized smectite (marketed by Kunimine Industries Co., Ltd., trade name: Smecton SA) was dispersed and swollen in 100 g of pure water, and then 2 g of sodium polyacrylate was added and further dispersed. The obtained solution was poured in a container made of fluorine resin having a flat bottom and a depth of 2 mm. After drying it at 100°C to remove water, a comparative thin film was obtained. The thin film could be easily peeled from the container. The thin film was transparent and had a thickness of 100 µm.

### Comparative Example 2

Similar to Example 1, 5 g of the organized clay was dispersed and swollen in 100 g of toluene. The obtained solution was poured in a container made of fluorine resin having a flat bottom and a depth of 2 mm. After removing the solvent by leaving to rest at room temperature, remaining solvent was thoroughly removed by a hot wind dryer at 150°C to obtain a thin film of this comparative example. The thin film could be easily peeled from the container. The thin film was transparent and had a thickness of 100 µm.

### Comparative Example 3

Similar to Example 1, 5 g of the organized clay was dispersed and swollen in 100 g of toluene. Then, 4 g of thermosetting epoxy resin was added and further dispersed. The obtained solution was poured in a container made of fluorine resin having a flat bottom and a depth of 2 mm. After removing the solvent by leaving to rest at room temperature, remaining solvent was thoroughly removed by a hot wind dryer at 150°C to obtain a thin film of this comparative example. The thin film could be easily peeled from the container. The thin film containing epoxy resin was transparent and had a thickness of 100 µm.

### (Evaluation of properties)

The thin films and the thin film laminates obtained in Examples 1 to 8 and Comparative Examples 1 to 3 were evaluated as follows

### (1) Appearance after water immersion

The thin film and the thin film laminate obtained in Examples 1 to 8 and Comparative Examples 1 to 3 were cut to obtain a test piece of 3 cm x 3 cm. The obtained test pieces were immersed in water for one hour. After immersion, the appearance of the test pieces was observed. The results are shown in Table 1.

### (2) Appearance after bending

The thin film and the thin film laminate obtained in Examples 1 to 8 and Comparative Examples 1 to 3 were cut to obtain a test piece of 3 cm x 6 cm. Then, the test pieces were twisted around a round bar having a diameter of 20 mm, and the appearance of the test pieces was observed. The results are shown in Table 1.

### (3) Appearance after heating

The thin film and the thin film laminate obtained in Examples 1 to 8 and Comparative Examples 1 to 3 were cut to obtain a test piece of 3 cm x 3 cm. The obtained test pieces were heated in an oven at 200°C for 15 minutes, and 250°C for 15 minutes. After heating, the appearance of the test pieces was observed. The results are shown in Table 1.

### (4) Total light transmittance

The total light transmittance of the thin films and the thin film laminates obtained in Examples I to 8 and Comparative Examples 1 to 3 after and without heating was measured using a hazemeter (marketed by Nippon Denshoku Co., Ltd.; trade name. Haze Meter NDH2000). The results are shown in Table 2.

### (5) Coefficient of thermal expansion

The coefficient of thermal expansion of the thin films and the thin film laminates obtained in Examples 1 to 4 and Comparative Examples 1 to 3 was measured in accordance with the coefficient of thermal expansion test method (JIS K 7197). The result is shown in Table 2.

### (6) Moisture vapor permeability

The moisture vapor permeability of the thin films and the thin film laminates obtained in Examples 1 to 4 and Comparative Examples 1 to 3 was measured by a differential pressure type gas chromatograph method in accordance with JIS K 7126 A method (differential pressure method) using a gas and steam permeability measuring device (marketed by GTR Tec Corporation). The results are shown in Table 2. Moisture vapor permeability was performed under conditions of 40°C/90%RH.

**[Table 1]**

| | Appearance after *water immersion* | Appearance after *bending* | Appearance after *heating at 200°C* | Appearance after *heating at 250°C* |
|---|---|---|---|---|
| Example 1 | No change | No change | No change | slightly colored |
| Example 2 | No change | No change | No change | Nochange |
| Example 3 | No change | No change | No change | No change |
| Example 4 | No change | No change | No change | No change |
| Example 5 | No change | No change | No change | No change |
| Example 6 | No change | No change | No change | No change |
| Example 7 | No change | No change | No change | No change |
| Example 8 | No change | No change | No change | No change |
| Comparative Example 1 | Dissolved | Cracked and broken | No flexibility | No flexibility |
| Comparative Example 2 | No change | Cracked and broken | Browned | Blackened |
| Comparative Example 3 | No change | No change | Browned | Blackened |

It is clear from Table 1 that the thin films and the thin film laminates obtained in Examples 1 to 8 had no change in appearance after water immersion, bending, and heating. Thereby, it was confirmed that they were excellent in water resistance, heat resistance, and flexibility.
In contrast, the thin film obtained in Comparative Example 1 had inferior flexibility, and the thin films obtained in Comparative Examples 2 and 3 had inferior heat resistance.

**[Table 2]**

| | Total light transmittance (%) | | | Coefficient of thermal expansion | Moisture vapor permeability |
|---|---|---|---|---|---|
| | No heating | After heating at 200°C | After heating at 250°C | (ppm/°C) | (g/m²·day) |
| Example 1 | 90.5 | 90.1 | 81.3 | 48 | 0.85 |
| Example 2 | 90.3 | 90.2 | 90.2 | 44 | 0.75 |
| EXample 3 | 89.8 | 88.8 | 88.1 | 38 | 0.64 |
| Example 4 | 87.7 | 87.6 | 87.6 | 28 | Less than 1.0×10⁻⁵ |
| Comparative Example 1 | 91.0 | 91.0 | 909 | -50 | Measurement impossible |
| | | | | (Shrinkage occurred) | |
| Comparative Example 2 | 88.6 | 712 | - | Measurement impossible due to breakage of the thin film | Measurement impossible due to breakage of the thin film |
| Comparative Example 3 | 87.8 | 65.4 | - | 100 | 1.01 |

It is clear from Table 2 that the thin films and the thin film laminates obtained in Examples 1 to 4 had total light transmittance of 81% or greater with no heating, or after heating. In addition, they had no practical problems in coefficient of thermal expansion and moisture vapor permeability.
In contrast, the thin film obtained in Comparative Example 1 had such serious shrinkage that the moisture vapor permeability could not be measured. The thin film obtained in Comparative Examples 2 and 3 has such low total light transmittance after heating that it could not be measured. In addition, the coefficient of thermal expansion and moisture vapor permeability could also not be measured, or had practical problems.

### Example 9

### (Production of organized clay)

After dispersing 5 g of tetradecyl trimethyl ammonium bromide in 50 g of pure water, 5g of synthesized smectite (marketed by Kunimine Industries Co., Ltd., trade name: Smecton SA) was added, and completely dispersed and swelled. After removing the liquid contained in the mixture by carrying out a solid-liquid separation using a centrifugal separator, 50 g of pure water was further added, dispersed, and the solid and liquid were separated again. After repeating the dispersion and the solid-liquid separation until foam was not formed, the moisture was thoroughly removed by a dryer. Thereby, hydrophilic exchangeable cations contained in the clay were exchanged with tetradecyl trimethyl ammonium ions. Organized clay having swelling properties to toluene, which is a non-polar solvent, was obtained.

### (Production of a clay thin film)

The obtained organized clay was crushed. 10 g of the organized clay was dispersed and swollen in 100 g of toluene. Then, 0.5 g of epoxy-modified dimethyl phenyl silicone oil having an epoxy group (marketed by Shin-Etsu Chemical Corporation Ltd.; trade name: X-22-2000) and 0.25 g of an acid anhydride curing agent (marketed by New Japan Chemical Co., Ltd.: trade name: Rikacid MH-700) were added, and dispersed. The obtained solution was coated on a polyethylene terephthalate film (abbreviated as "PET film") which was subjected to a releasing treatment in advance using an applicator to obtain a film. After that, it was put into a dryer at 100°C to remove the solvent. Then, the thin film of this example was obtained by peeling from the PET film, and heating at 170°C for two hours to crosslink the epoxy-modified silicone oil. The thin film was transparent and flexible, and had a thickness of 80 µm.

### Example 10

A thin film having a thickness of 80 µm of this example was prepared in a manner identical to that of Example 9 of the present invention, except that the content of the epoxy-modified dimethyl phenyl silicone oil (marketed by Shin-Etsu Chemical Corporation Ltd.; trade name: X-22-2000) was changed to 5 g and the content of the acid anhydride curing agent (marketed by New Japan Chemical Co., Ltd.: trade name: Rikacid MH-700) was changed to 2.5 g.

### Example 11

A thin film having a thickness of 80 µm of this example was prepared in a manner identical to that of Example 9 of the present invention, except that the content of the epoxy-modified dimethyl phenyl silicone oil (marketed by Shin-Etsu Chemical Corporation Ltd.; trade name: X-22-2000) was changed to 10 g and the content of the acid anhydride curing agent (marketed by New Japan Chemical Co., Ltd.: trade name: Rikacid MH-700) was changed to 5 g.

### Example 12

A thin film having a thickness of 80 µm of this example was prepared in a manner identical to that of Example 9 of the present invention, except that 5 g of tetradecyl trimethyl ammonium bromide was replaced with 5 g of octadecyl triphenyl phosphonium bromide,

### Example 13

A thin film having a thickness of 80 µm of this example was prepared in a manner identical to that of Example 9 of the present invention, except that epoxy-modified dimethyl phenyl silicone oil (marketed by Shin-Etsu Chemical Corporation Ltd.; trade name: X-22-2000) was replaced with amino-modified dimethyl phenyl silicone oil (marketed by Shin-Etsu Chemical Corporation Ltd.; trade name: X-22-1660B-3).

### Example 14

A thin film having a thickness of 80 µm of this example was prepared in a manner identical to that of Example 9 of the present invention, except that 1 g of thermosetting epoxy resin having a bisaryl fluorine as a basic structure (marketed by Nagase & Co., Ltd.: trade name. EX1020) was further added in forming the thin film.

### Example 15

A thin film laminate of this example was prepared by coating ultraviolet-curable urethane acrylate (Nippon Synthetic Chemical Industry Co., Ltd.: trade name: Purple Light UV7600B), which was a hard coating material, on both surfaces of the thin film obtained in Example 9, curing by ultraviolet ray irradiation, and thereby forming a hard coat layer having a thickness of 1 µm.

### Example 16

A thin film laminate of this example was prepared by forming a SiOx film having 60 µm, which is an inorganic layer, by a reactive sputtering device on both surfaces of the thin film obtained in Example 9.

### Comparative Example 4

A thin film of this comparative example was prepared by dispersing and swelling 5 g of the organized clay obtained in Example 9 in 100 g of toluene without adding the heat-resistant fluid, and coating the obtained solution on a PET film which was subjected to a releasing treatment in advance using an applicator to obtain a film. After that, it was put into a dryer at 100°C to remove the solvent. Then, the thin film having a thickness of 80 µm of this comparative example was obtained by peeling from the PET film.

### Comparative Example 5

A thin film having a thickness of 80 µm of this comparative example was prepared in a manner identical to that of Example 9 of the present invention, except that the epoxy-modified dimethyl phenyl silicone oil was replaced with 1 g of dimethyl silicone oil (marketed by Shin-Etsu Chemical Corporation Ltd.; trade name: KF-54), which was a non-reactive fluid, and the acid anhydride curing agent was not added.

### (Evaluation of properties)

The thin films and the thin film laminates obtained in Examples 9 to 16 and Comparative Examples 4 and 5 were evaluated as follows.

### (1) Flexibility

### [Appearance after bending]

The thin films and thin film laminates were twisted around a round bar having a diameter of 15 mm, and the appearance of the test pieces was observed.

### (2) Heat resistance

### [Appearance after heating]

The thin films and the thin film laminates were left to rest in a thermostat bath at 200°C and 250°C for one hour, and the appearance thereof was observed.

### [Coefficient of thermal expansion]

The coefficient of thermal expansion of the thin films and the thin film laminates was measured in accordance with ASTM-D696.

### (3) Water resistance

### [Moisture vapor permeability]

The moisture vapor permeability of the thin films and the thin film laminates was measured by a differential pressure type gas chromatograph method in accordance with JIS K 7126 A method (differential pressure method) using a gas and steam permeability measuring device (marketed by using GTR Tec Corporation) under conditions of 40°C/90%RH.

### (4) Transparency

### [Total light transmittance]

The total light transmittance of the thin films and the thin film laminates was measured using a hazemeter (marketed by Nippon Denshoku Co., Ltd.; Haze Meter NDH2000).

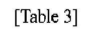

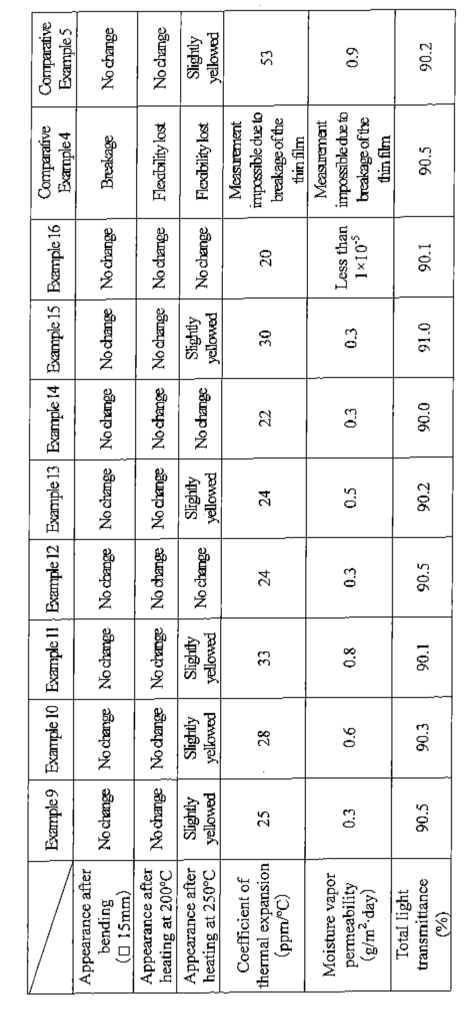

It is clear from Table 3 that the thin films and thin film laminates obtained in Examples 9 to 16 had no change in appearance after bending, and had flexibility. In addition, they had no change in appearance after heating at 200°C, and had sufficient heat resistance. Furthermore, they had coefficient of thermal expansion of 33 ppm/°C or less, and had excellent heat resistance in size stability. They had moisture vapor permeability of 0.8 g/m²·day or less, and excellent water resistance. They had total light transmittance of 90% or more, and excellent transparency.
In contrast, breakage was generated in the thin film obtained in Comparative Example 4 after bending, and they had no flexibility. In addition, the thin film obtained in Comparative Example 5 had a coefficient of thermal expansion of 53 ppm/°C, and insufficient heat resistance. Therefore, it was confirmed that the thin film obtained in Comparative Example 5 had inferior size stability and had problems in workability.

### INDUSTRIAL APPLICABILITY

Since the thin film of the present invention has excellent properties, it can be used in various products. For example, the thin film of the present invention can be used as a substrate for electronic paper, a sealing film for an electronic device, a lens film, a film for a light guide plate, a prismatic film, a film for a retardation plate, a film for a polarization plate, a film for compensating view angle, a film for a PDP, a film for an LED, an optical communication member, a film for a touch panel, a substrate for various functional films, a film for an electronic device which allows the inside thereof to be viewed, a film for an optical recording medium such as a video disc, CD, CR-R, CR-RW, DVD, MO, MD, a phase-change disc, and an optical card, a film for sealing a fuel cell, a film for a solar cell, and the like.
The thin film laminate of the present invention has high gas barrier properties. The thin film laminate of the present invention can be preferably used as a film substrate for a liquid or an organic EL display.

## Claims

1. A thin film comprising a heat-resistant fluid between layers comprising heat-resistant flakes.

2. A thin film according to claim 1, wherein the heat-resistant flake is clay mineral.

3. A thin film according to claim 2, wherein the clay mineral is at least one selected from the group consisting of mica, vermiculite, montmorillonite, iron montmorillonite, beidellite, saponite, hectorite, stevensite, nontronite, magadiite, ilerite, kanemite, layered titanic acid, and smectite.

4. A thin film according to claim 1, wherein the heat-resistant fluid is at least one selected from the group consisting of polyalkylene glycol, phosphoric ester, alkylbenzene, poly-α-olefin, polyol ester, alkyl naphthalene, silicone oil, halocarbon, polyaryl alkane, polyphenyl, silicate, and polyphenyl ether.

5. A thin film according to claim 1, wherein the content of the heat-resistant fluid is 1 to 60% by weight relative to 100% of the thin film.

6. A thin film according to claim 5, wherein the content of the heat-resistant fluid is 5 to 60% by weight relative to 100% of the thin film.

7. A thin film according to claim 1, wherein the heat-resistant fluid has a reactive functional group.

8. A thin film according to claim 7, wherein the heat-resistant fluid having a reactive functional group is silicone oil having a reactive functional group.

9. A thin film according to claim 8, wherein the silicone oil having a reactive functional group is methyl phenyl silicone oil or modified methyl phenyl silicone oil.

10. A thin film according to claim 1, wherein the heat-resistant fluid contains a hydrphobic cationic compound.

11. A thin film according to claim 10, wherein the hydrophobic cationic compound is at least one selected from the group consisting of a quartemary ammonium salt, a quartemary phosphonium salt, a pyridinium salt, and an imidazolium salt.

12. A thin film according to claim 11, wherein the heat-resistant fluid contains resin which is in a solid state at room temperature.

13. A thin film according to claim 10, wherein the resin has a functional group reactive with the heat-resistant fluid.

14. A thin film according to claim 11, wherein the resin makes a crosslink structure with the heat-resistant fluid.

15. A thin film according to claim 10, wherein the content of the resin is 50% by weight or less relative to 100% of the thin film.

16. A thin film laminate comprising the thin film according to claim 1, and one or more of at least one of an inorganic thin film and an organic thin film is layered on one surface or both surfaces of the thin film.

17. A thin laminate according to claim 14, wherein the inorganic thin film is a film comprising silicone oxide or silicone oxide nitride which is made by a sputtering method or a plasma CVD method.

18. A thin film laminate according to claim 14, wherein the organic thin film is a film made by coating an organic polymer.

## Amended claims

### Amended claims under Art. 19.1 PCT

**1.** A thin film comprising a heat-resistant fluid between layers comprising heat-resistant flakes.

**2.** A thin film according to claim 1, wherein the heat-resistant flake is clay mineral.

**3.** A thin film according to claim 2, wherein the clay mineral is at least one selected from the group consisting of mica, vermiculite, montmorillonite, iron montmorillonite, beidellite, saponite, hectorite, stevensite, nontronite, magadiite, ilerite, kanemite, layered titanic acid, and smectite.

**4.** A thin film according to claim 1, wherein the heat-resistant fluid is at least one selected from the group consisting of polyalkylene glycol, phosphoric ester, alkylbenzene, poly-α-olefin, polyol ester, alkyl naphthalene, silicone oil, halocarbon, polyaryl alkane, polyphenyl, silicate, and polyphenyl ether.

**5.** A thin film according to claim 1, wherein the content of the heat-resistant fluid is 1 to 60% by weight relative to 100% of the thin film.

**6.** A thin film according to claim 5, wherein the content of the heat-resistant fluid is 5 to 60% by weight relative to 100% of the thin film.

**7.** A thin film according to claim 1, wherein the heat-resistant fluid has a reactive functional group.

**8.** A thin film according to claim 7, wherein the heat-resistant fluid having a reactive functional group is silicone oil having a reactive functional group.

**9.** A thin film according to claim 8, wherein the silicone oil having a reactive functional group is methyl phenyl silicone oil or modified methyl phenyl silicone oil.

**10.** A thin film according to claim 1, wherein the heat-resistant fluid contains a hydrphobic cationic compound.

**11.** A thin film according to claim 10, wherein the hydrophobic cationic compound is at least one selected from the group consisting of a quarternary ammonium salt, a quarternary phosphonium salt, a pyridinium salt, and an imidazolium salt.

**12.** A thin film according to claim 11, wherein the heat-resistant fluid contains resin which is in a solid state at room temperature.

**13.** A thin film according to claim 12, wherein the resin has a functional group reactive with the heat-resistant fluid.

**14.** A thin film according to claim 13, wherein the resin makes a crosslink structure with the heat-resistant fluid.

**15.** A thin film according to claim 12, wherein the content of the resin is 50% by weight or less relative to 100% of the thin film.

**16.** A thin film laminate comprising the thin film according to claim 1, and one or more of at least one of an inorganic thin film and an organic thin film is layered on one surface or both surfaces of the thin film.

**17.** A thin laminate according to claim 16, wherein the inorganic thin film is a film comprising silicone oxide or silicone oxide nitride which is made by a sputtering method or a plasma CVD method.

**18.** A thin film laminate according to claim 16, wherein the organic thin film is a film made by coating an organic polymer.
